# EUROPEAN PATENT SPECIFICATION

(11) **EP 0 496 223 B1**
(45) Date of publication and mention of the grant of the patent: **03.04.1996**
(21) Application number: 92100348.9
(22) Date of filing: 10.01.1992
(51) Int. Cl.: G02F 1/136

(54) **Element substrate for liquid crystal display devices and its production method**
Elementsubstrat für Flüssigkristall-Anzeigevorrichtungen und Verfahren zu dessen Herstellung
Substrat à élément pour dispositifs d'affichage à cristal liquide et procédé de fabrication de celui-ci

(30) Priority: 25.01.1991 JP 25355/91
(43) Date of publication of application: 29.07.1992
(73) Proprietor: SEIKO EPSON CORPORATION, Shinjuku-ku Tokyo-to (JP)
(72) Inventor: Takahashi, Kotoyoshi, c/o Seiko Epson Corp., Suwa-shi, Nagano-ken (JP)
(74) Representative: Hoffmann, Eckart, Dipl.-Ing.

(56) References cited:
- EP-A- 0 255 850
- US-A- 4 534 623
- US-A- 4 683 183
- "Japan Display '83", pp.404-407, S.Morozumi et al., "A 250x250 Element LCD Addressed by Lateral MIM".

## Description

The present invention relates to liquid crystal display devices and more particularly to the element substrates of liquid crystal display devices in which nonlinear elements are arranged in a matrix corresponding to the display screen. The present invention further relates to a production method for such element substrates.

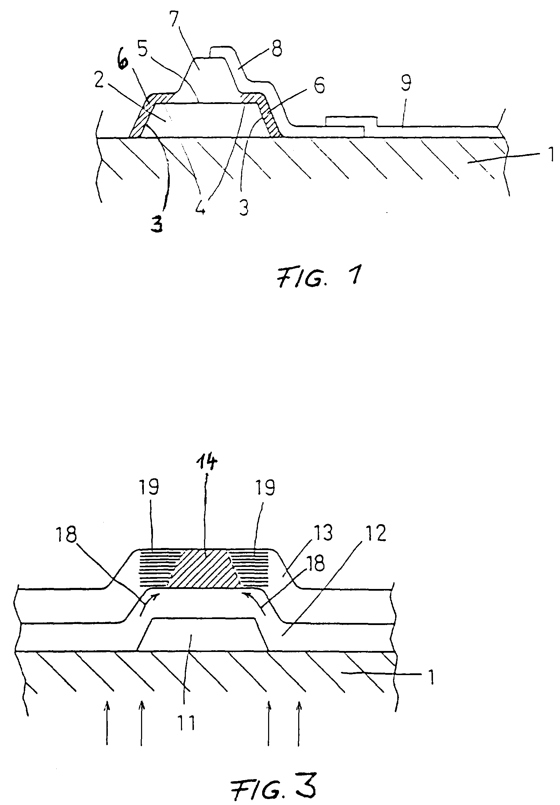

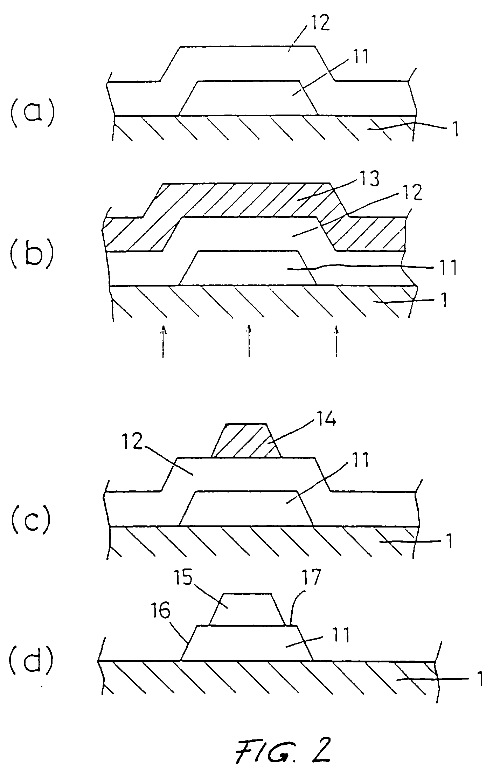

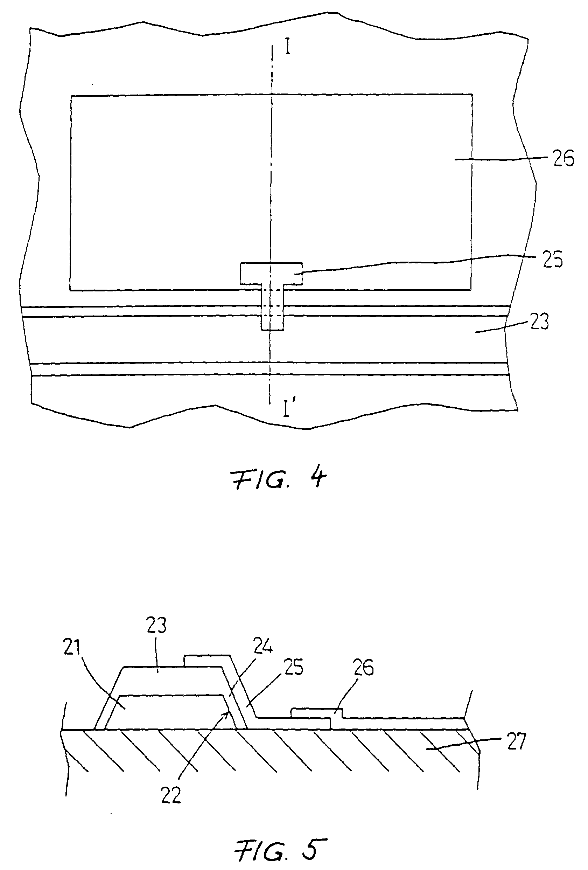

Fig. 4 is a top view of a prior art element substrate as disclosed in Japan Display '83, pp. 404-407, S. Morozumi et al. "A 250x240 Element LCD Addressed by Lateral MIM". In this prior art metal-insulator-metal (MIM) elements are used as the elements (hereinafter referred to as "pixel elements") for driving the pixels. Fig. 5 is a cross section (along line I-I') of the same element substrate. Both figures show that a lateral (side surface) MIM structure is used in which only the side surface 22 of a first conductor 21 is utilized as the pixel element.

In lateral MIM elements, all surfaces except the side surface 22 of the first conductor 21, i.e. the part where MIM structure is formed, are covered with a barrier layer 23. The barrier layer 23 has an electrical resistance high enough to avoid an MIM function to occur in parts where this barrier layer 23 is provided. In the figure, 25 is a second conductor, 26 a pixel electrode and 27 a transparent substrate. The part, where the first conductor 21, the insulator 24 and the second conductor 25 overlap each other becomes a pixel element, i.e. a non-linear element, for driving the pixel electrode 26 of the liquid crystal display device.

Known materials used for the conductors in MIM elements include Ta, Al, Au, ITO, NiCr+Au and ITO+Cr. Known materials for the insulator 24 include TaOx, SiNx, SiOxNy, TaNx, AlOx and ZnOx. These insulators are formed by thermal or anodic oxidation or by sputtering.

In addition to the above inorganic compounds used as the insulator, polyimides and other organic compounds are also used in the barrier layer.

The most common structure used in MIM elements is one that employs tantalum (Ta) for the first conductor 21, tantalum oxide (TaOx) for the insulator 24 and chrome (Cr) for the second conductor (Ta/TaOx/Cr structure).

However, in the element substrate of liquid crystal display devices that use the above prior art MIM element, the MIM element is formed on the side surface of the first conductor and where the insulator 24 and second conductor 25 overlap, and therefore the size of the MIM elements is not consistent due to deviations in the surface area of the side surface 22 formed in the production process, thus resulting in deviations in the characteristics of many MIM elements functioning as pixel elements.

The deviations in the surface area of the side surface 22 are caused by an inconsistent distribution of the film thickness of the first conductor 21 (the surface area of the MIM element is proportional to the film thickness of the first conductor 21) and of the angel formed between the side surface 22 and the transparent substrate 27, i.e., the cross sectional shape of the side surface (shape of taper).

The inconsistency in the element surface area of the MIM element and the inability to control the element surface area in the production process leads to the serious problem in the liquid crystal display device of not being able to control the display condition of the pixels.

The purpose of the invention is to offer an element substrate for liquid crystal display devices and its production method that will solve the above problems and provide a uniform characteristic, even in large surface area liquid crystal display devices.

This object is achieved with an element substrate and a production method, respectively, as claimed.

Embodiments of the present invention will be described below in more detail with reference to the drawings, in which:
- Fig. 1: is a cross section showing an embodiment of the element substrate of the invention;
- Fig. 2: are cross sections during various steps of an embodiment of the production method of the invention;
- Fig. 3: is a cross section to explain an exposure step of an embodiment of the production method of the invention;
- Fig. 4: is a top view of an element substrate of a prior art liquid crystal device; and
- Fig. 5: is a cross section of an element substrate of a prior art liquid crystal display device.

Fig. 1 is a cross section of the element substrate of the invention, where 1 is the transparent substrate, on which is formed a transparent base film, 2 is a first conductor, 3 are the side surfaces of the first conductor, 4 are the upper edges of the first conductor, 5 is the remaining part of the top surface of the first conductor 2 not including the top edges 4, 6 is a first insulator, 7 is a second insulator, 8 is a second conductor and 9 is a pixel electrode. The second insulator 7 is formed on the part 5 of the top surface, and since it is thicker than the first insulator 6, the part that functions as a nonlinear pixel element formed by the first conductor 2, the second conductor 8 and the insulator therebetween is the part where the first conductor 2, the first insulator 6 and the second conductor 8 overlap and not the part where the first conductor 2, the second insulator 7 and the second conductor 8 overlap.

The first insulator 6 which contributes to the pixel element is formed on the top edges 4 of the first conductor 2 as well as the side surfaces 3. Therefore, the surface area of the pixel element is the total of one side surface 3 and one of the top edges 4.

One problem of prior art MIM elements have been deviations in the surface area of the side surfaces 3; that is, the surface area of the side surfaces 3 varied due to deviations in the film thickness and taper shape of the first conductor 2 in the production process. However, the element substrate of the invention is capable of absorbing such deviations in the surface areas 3 with the surface area of the upper edges 4. Therefore, as described below, the film thickness of a positive resist 13 shown in Fig. 2 and the first conductor 2 and the amount of exposure light from the rear surface need only be optimized. As a result, deviations in the pixel element surface area, which is the total of the side surfaces 3 and the top edges 4, can be essentially eliminated.

Next is an explanation based on Fig. 2 of the production process of the element substrate of the liquid crystal display device of the invention. Fig. 2(a) is a cross section showing the transparent substrate 1 formed from a transparent TaOx film as the base film, on which are formed a Ta electrode 11 as the first conductor and a TaOx film 12. The Ta electrode 11 is formed by photo-etching, and the TaOx film 12 is then formed as the barrier layer by sputtering or chemical vapor deposition (CVD). In this embodiment, the TaOx film 12 is also formed on the transparent substrate 1, but it need only be formed on the Ta electrode 11 and its side surfaces.

Next, the positive resist 13 is applied to the surface of the TaOx film 12 as shown in Fig. 2(b), and is then exposed from the opposite surface of the transparent substrate 1, i.e., rear surface of the transparent substrate 1 (direction of arrows). As a result, only the positive resist above the Ta electrode 11, which is not transparent, is not exposed since the TaOx film 12 and other oxide or nitride films are transparent to the exposure light. Therefore, when developed, only part 14 of the resist above the Ta electrode 11 remains as shown in Fig. 2(c), in which condition etching is performed until the side surfaces of the Ta electrode 11 are exposed, resulting in the condition shown in Fig. 2(d).

In (d) of the same figure, 15 is the remaining part of the TaOx film, which becomes the second insulator used as the barrier layer, 16 are the side surfaces of the Ta electrode 11 and 17 are the top edges of the Ta electrode 11. The side surfaces 16 and the top edges 17 are surfaces of the Ta electrode 11. When etching is performed, the part of the TaOx film 12 having the resist 14 on top of it is not etched and only the other parts of the TaOx film 12 are etched as shown in Fig. 2(c). The etching rate of the TaOx film 12 is constant, and therefore when the TaOx film 12 is etched, etching reaches the side surfaces 16 and the top edges 17 at the same time.

An important factor in this process is controlling of the position of the part 14 of the resist left by exposure and developing. The exposure light contains a diffraction component 18 as shown in Fig. 3, and so only parts 19 of the positive resist 13 present on top of the Ta electrode 11 are sensitized by the exposure light in the exposure shown in Fig. 2(b). Therefore, the position of part 14 of the resist remaining due to development can be controlled by appropriately setting the exposure conditions in advance.

As a specific example, pixel elements with little deviation in the element surface area can be achieved by a production process based on the conditions below.

| | |
|---|---|
| Film thickness of Ta electrode 11: | 250 nm |
| Film thickness of TaOx film 12: | 300 nm |
| Film thickness of positive resist 14: | 1300 nm |
| Exposure energy from rear surface: | 70 mJ/cm |

A thin TaOx film is formed as the first insulator on the side surfaces 16 and top edges 17 of the Ta electrode 11 by anodic or thermal oxidation from the condition in Fig. 2(d), and then Cr as the second conductor and the pixel electrode is formed and the Cr pattern and pixel electrode pattern are formed by photo-etching, whereby the element shown in Fig. 1 is produced.

## Claims

1. An element substrate for liquid crystal display devices comprising a transparent substrate (1) with a first conductor (2), an insulating layer (6, 7) and a second conductor (8) formed by sequential lamination thereon, the insulating layer comprising a first insulator (6) and a second insulator (7), wherein the second insulator (7) is thicker than the first insulator (6), and wherein the overlapping parts of the first conductor (2), the first insulator (6) and the second conductor (8) constitute non-linear elements arranged to drive pixel electrodes (9) of the liquid crystal display device,
characterized in that
the first insulator (6) is formed only on the side surfaces (16) and top edges (17) of the first conductor and the second insulator (7) is formed only on the remaining area of the top surface of the first conductor (2).

2. A method of producing the element substrate for liquid crystal display devices of claim 1 wherein the first conductor (11) is formed on the transparent substrate (1), a transparent insulator (12) and positive resist (13) are applied in films on the top and side surfaces of the first conductor, after which the positive resist located on the upper edges (17) and the side surfaces (16) of the first conductor is exposed from the under side of the transparent substrate until it is photosensitized and is then developed, the insulator is etched until the sides and upper edges of the first conductor are exposed, and the first insulator and second conductor are formed sequentially on the sides and upper edges of the first conductor, whereby the non-linear driving element is formed.

## Patentansprüche

1. Elementensubstrat für Flüssigkristallanzeigevorrichtungen, umfassend ein transparentes Substrat (1) mit einem ersten Leiter (2), einer Isolierschicht (6, 7) und einem zweiten Leiter (8), die darauf durch sequentielle Laminierung ausgebildet sind, wobei die Isolierschicht einen ersten Isolator (6) und einen zweiten Isolator (7) umfaßt, der zweite Isolator (7) dicker ist als erste Isolator (6), und wobei die überlappenden Teile des ersten Leiters (2), des ersten Isolators (6) und des zweiten Leiters (8) nicht-lineare Elemente bilden, die angeordnet sind, um Pixelelektroden der Flüssigkristallanzeigevorrichtung anzusteuern,
dadurch gekennzeichnet, daß der erste Isolator (6) nur auf den Seitenflächen (16) und den Oberkanten (17) des ersten Leiters ausgebildet ist und der zweite Isolator (7) nur auf der übrigen Fläche der Oberseite des ersten Leiters (2) ausgebildet ist.

2. Verfahren zur Herstellung des Elementensubstrats für Flüssigkristallanzeigevorrichtung nach Anspruch 1, bei dem ein erster Leiter (11) auf dem transparenten Substrat (1) ausgebildet wird, ein transparenter Isolator (12) und ein Positiv-Resist (13) als Filme auf der Oberseite und den Seitenflächen des ersten Leiters aufgebracht werden, wonach der Positiv-Resist, der auf den Oberkanten (17) und den Seitenflächen (16) des ersten Leiters angeordnet ist, von der Unterseite des transparenten Substrats her belichtet wird, bis er photosensitiviert ist und dann entwickelt wird, der Isolator geätzt wird, bis die Seiten und die Oberkanten des ersten Leiters freigelegt sind und der erste Isolator und der zweite Leiter nacheinander auf den Seiten und den Oberkanten des ersten Leiters ausgebildet werden, wodurch das nicht-lineare Ansteuerungselement gebildet wird.

## Revendications

1. Substrat à éléments pour dispositifs d'affichage à cristaux liquides comprenant un substrat transparent (1) avec un premier conducteur (2), une couche isolante (6, 7) et un second conducteur (8) formés par dépôts successifs sur celui-ci, la couche isolante comprenant un premier isolant (6) et un second isolant (7), dans lequel le second isolant (7) est plus épais que le premier isolant (6), et dans lequel les parties se chevauchant du premier conducteur (2), du premier isolant (6) et du second conducteur (8) constituent des éléments non linéaires disposés pour commander des électrodes de pixels (9) du dispositif d'affichage à cristaux liquides,
caractérisé en ce que
le premier isolant (6) est formé seulement sur les surfaces latérales (16) et les bords supérieurs (17) du premier conducteur et le second isolant (7) est formé seulement sur la zone restante de la surface supérieure du premier conducteur (2).

2. Procédé de fabrication du substrat à éléments pour dispositifs d'affichage à cristaux liquides selon la revendication 1 dans lequel le premier conducteur (11) est formé sur le substrat transparent (1), un isolant transparent (12) et un résist positif (13) sont appliqués en films sur les surfaces supérieure et latérales du premier conducteur, après quoi le résist positif situé sur les bords supérieurs (17) et les surfaces latérales (16) du premier conducteur est exposé par le côté inférieur du substrat transparent jusqu'à ce qu'il soit photo-sensibilisé et est ensuite développé, l'isolant est gravé jusqu'à ce que les côtés et les bords supérieurs du premier conducteur soient découverts, et le premier isolant et le second conducteur sont formés successivement sur les côtés et les bords supérieurs du premier conducteur, l'élément de commande non linéaire étant ainsi formé.
